(19) Europäisches Patentamt / European Patent Office / Office européen des brevets

(11) **EP 3 262 661 B1**

(12) **FASCICULE DE BREVET EUROPEEN**

(45) Date de publication et mention de la délivrance du brevet:
**14.04.2021 Bulletin 2021/15**

(21) Numéro de dépôt: **16714984.8**

(22) Date de dépôt: **25.02.2016**

(51) Int Cl.:
*H01B 12/16* (2006.01)  *F25B 21/02* (2006.01)
*H01L 37/00* (2006.01)  *H01L 39/14* (2006.01)

(86) Numéro de dépôt international:
**PCT/FR2016/050442**

(87) Numéro de publication internationale:
**WO 2016/135428 (01.09.2016 Gazette 2016/35)**

(54) **TRAITEMENT THERMIQUE D'UN CÂBLE ÉLECTRIQUE**

WÄRMEBEHANDLUNG EINES ELEKTRISCHEN KABELS

HEAT TREATMENT OF AN ELECTRICAL CABLE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.02.2015 FR 1551663**

(43) Date de publication de la demande:
**03.01.2018 Bulletin 2018/01**

(73) Titulaires:
• **Ecole Supérieure de Physique et de Chimie Industrielles de la Ville de Paris**
**75005 Paris (FR)**
• **Centre National de la Recherche Scientifique (C.N.R.S.)**
**75016 Paris (FR)**

(72) Inventeur: **DE' MEDICI, Luca**
**38000 Grenoble (FR)**

(74) Mandataire: **Plasseraud IP**
**66, rue de la Chaussée d'Antin**
**75440 Paris Cedex 09 (FR)**

(56) Documents cités:
**DE-B- 1 241 469  DE-B- 1 244 209**

• **J. L. COHN ET AL: "Giant Nernst Effect and Bipolarity in the Quasi-One-Dimensional Metal Li(0.9)Mo(6)O(17)", PHYSICAL REVIEW LETTERS, vol. 108, no. 5, 2 février 2012 (2012-02-02), pages 056604-1, XP055236287, US ISSN: 0031-9007, DOI: 10.1103/PhysRevLett.108.056604 cité dans la demande**
• **Ye. A. Kolenko: "THERMOELECTRIC COOLING DEVICES - Technical Translation FSTC-HT-23-435-68", , 2 septembre 1969 (1969-09-02), pages 1-348, XP055235949, internet Extrait de l'Internet: URL:http://www.dtic.mil/dtic/tr/fulltext/u 2/691974.pdf [extrait le 2015-12-14]**

EP 3 262 661 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention concerne le domaine des câbles électriques.

Dans de tels câbles, il est recherché de faire varier la température de l'âme d'un câble résistif ou supraconducteur (par exemple abaisser sa température).

Les câbles connus ne proposent pas de solutions alternatives à des circulations de fluides de refroidissement classiques, comme l'azote liquide pour le seul supraconducteur YBaCuO par exemple

Le document DE 1244209 B décrit un dispositif de refroidissement pour câbles supraconducteurs.

La présente invention vient améliorer cette situation.

Elle propose à cet effet un câble électrique selon la revendication 1, comportant une âme destinée à faire circuler un courant électrique principal générant un champ magnétique circulaire au moins à l'extérieur de l'âme. En particulier, le câble comporte au moins une gaine entourant l'âme et comportant un matériau thermomagnétique, conducteur pour faire circuler un courant électrique auxiliaire coopérant avec le champ magnétique circulaire pour générer, par effet Ettingshausen, un gradient de température entre l'âme du câble et l'extérieur de la gaine.

L'effet Ettingshausen consiste en la génération d'un gradient de température, avec par exemple une température plus froide au niveau de l'âme du câble et une température correspondant à la température ambiante à l'extérieur de la gaine, si le champ magnétique précité est perpendiculaire au courant auxiliaire circulant dans la gaine et si le matériau de la gaine a effectivement des propriétés thermomagnétiques. Ces propriétés se mesurent par une valeur dite de « figure de mérite » pour obtenir une différence de température mesurable entre l'intérieur et l'extérieur de la gaine. A titre d'exemple, la valeur de figure de mérite (« adimensionnelle, isotherme », telle que définie plus loin) du matériau de la gaine est ici supérieure à $10^{-2}$.

Dans un exemple de réalisation, le matériau thermomagnétique de la gaine comporte du bismuth (Bi). Ce matériau est avantageux en ce qu'il est relativement peu onéreux, facile d'utilisation et d'usinage et présente une valeur de figure de mérite élevée.

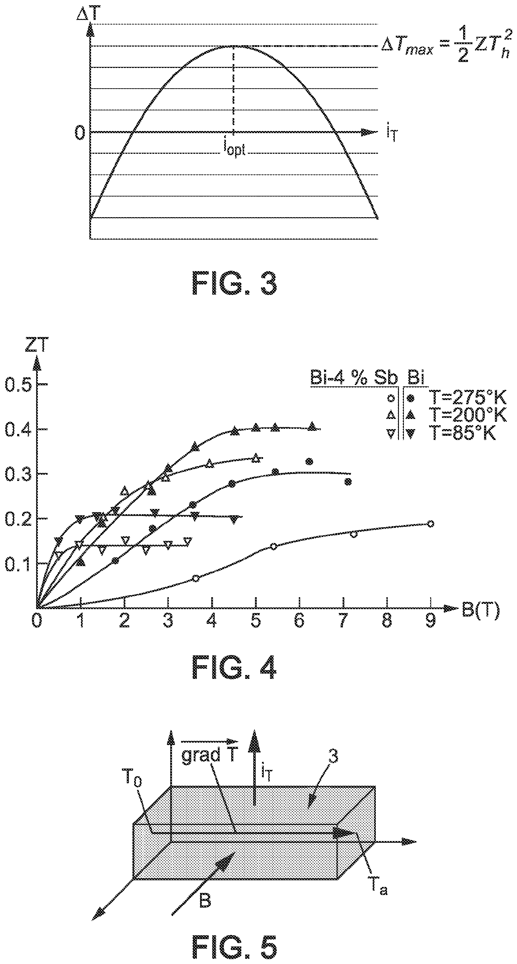

Dans une réalisation alternative ou variante, le matériau thermomagnétique de la gaine comporte un alliage de bismuth et d'antimoine (BiSb). Comme on le verra plus en détail en référence à la figure 4 décrite ci-après, un tel alliage présente une valeur de figure de mérite plus élevée que celle du bismuth, à des gammes de températures particulières. Ainsi, on comprendra que les propriétés thermomagnétiques du matériau utilisé pour la gaine sont fonctions de la température d'utilisation du matériau et qu'il est possible d'utiliser différents matériaux selon les gammes de températures visées dans l'application du câble.

A titre d'exemple, la proportion d'antimoine dans l'alliage est de moins de 10% pour obtenir des valeurs de figure de mérite satisfaisantes.

Dans un autre exemple de réalisation possible, le matériau thermomagnétique de la gaine peut comporter un oxyde de molybdène et lithium, ayant par exemple la composition $Li_{0,9}Mo_6O_{17}$. Là encore, ce matériau présente une valeur de figure de mérite avantageuse dans une gamme de température particulière et il est possible de choisir ce matériau en alternative du bismuth, ou en complément du bismuth en fonction d'une gamme de températures visée pour le fonctionnement du câble.

En effet, il est possible de prévoir plusieurs gaines (coaxiales) à propriétés thermomagnétiques adaptées respectivement à des gammes de températures différentes, pour refroidir progressivement l'âme du câble.

Ainsi, dans une réalisation, le câble peut comporter :

- une première gaine comportant un premier matériau thermomagnétique, conducteur pour faire circuler un premier courant auxiliaire et, de là, refroidir l'âme du câble, et
- au moins une seconde gaine entourant la première gaine et comportant un deuxième matériau thermomagnétique, conducteur pour faire circuler un deuxième courant auxiliaire et, de là, refroidir la première gaine,

les premier et deuxième matériaux thermomagnétiques étant différents et/ou les premier et deuxième courants auxiliaires étant différents.

Avantageusement, le câble au sens de l'invention s'applique à l'acheminement de courants supraconducteurs et dans une telle réalisation l'âme du câble peut comporter un matériau supraconducteur.

Dans une réalisation possible, la gaine comportant le matériau thermomagnétique est entourée d'une gaine de circulation d'un fluide de refroidissement (notamment dans le cas où l'abaissement de température dans l'âme du câble par effet Ettingshausen n'est pas suffisant pour atteindre l'effet supraconducteur).

Avantageusement, le câble comporte au moins un film isolant électrique entre l'âme et la gaine (permettant la circulation de deux courants distincts : le courant principal circulant dans l'âme, et le courant auxiliaire circulant dans la gaine).

La présente invention vise aussi un procédé de traitement en température de l'âme d'un câble électrique, selon la revendication 12, comportant les étapes :

- prévoir au moins une gaine entourant l'âme du câble, et comportant un matériau thermomagnétique, et
- concomitamment à une circulation de courant électrique principal dans l'âme, générant un champ magnétique circulaire au moins à l'extérieur de l'âme, faire circuler un courant électrique auxiliaire coopérant avec le champ magnétique circulaire pour générer, par effet Ettingshausen, un gradient de température entre l'âme du câble et l'extérieur de la gaine.

Dans une réalisation:

- le courant générant le champ magnétique circule le long de l'âme du câble, et
- le champ magnétique généré est perpendiculaire à l'âme.

On fait alors circuler le courant auxiliaire dans une direction parallèle à l'âme du câble pour générer un gradient de température dans une direction perpendiculaire à l'âme.
Plus particulièrement, on fait circuler le courant auxiliaire dans un sens choisi par rapport au courant circulant dans l'âme, pour générer un gradient de température refroidissant l'âme du câble.

Avantageusement, on prévoit un matériau supraconducteur dans l'âme du câble, et :

- on prévoit en outre une gaine de circulation d'un fluide de refroidissement entourant la gaine comportant le matériau thermomagnétique, et
- on injecte dans la gaine de circulation un fluide à une température plus basse qu'une température critique du matériau supraconducteur au moins pour amorcer un effet supraconducteur dans l'âme du câble.

D'autres avantages et caractéristiques de l'invention apparaitront à la lecture de la description détaillée, donnée ci-après à titre d'exemples non limitatifs, et à l'examen des dessins annexés sur lesquels :

- La figure 1 représente une structure de câble selon un exemple de réalisation de l'invention, en coupe longitudinale,
- La figure 2 représente une structure de câble en coupe transversale selon un exemple de réalisation de l'invention,
- La figure 3 illustre la variation de différence de températures en deux extrémités d'un matériau thermomagnétique en fonction du courant qui le traverse,
- La figure 4 représente les variations de valeurs de la figure de mérite isotherme du bismuth (en disques et triangles noirs) et de son alliage avec 4% d'antimoine (en disques et triangles blancs) en fonction du champ magnétique B, à différentes températures ambiantes,
- La figure 5 représente schématiquement les conditions de mesures des valeurs de la figure 4,
- La figure 6 représente schématiquement les conditions d'obtention de valeurs de figure de mérite plus élevées, dans le contexte de l'invention,
- La figure 7 illustre une structure de câble à plusieurs gaines à propriétés thermomagnétiques,
- La figure 8 représente les variations de valeurs de la figure de mérite (adiabatique) du $Li_{0,9}Mo_6O_{17}$ en fonction du champ magnétique B, à différentes températures ambiantes,
- La figure 9 illustre des valeurs de températures critiques, de densité de courant critique et de champ magnétique critique, pour différents matériaux supraconducteurs,
- La figure 10 illustre une application variante de l'invention à des bobines de câble de haute puissance, et
- La figure 11 illustre une autre application de l'invention à des câbles à bain d'huile,
- La figure 12 illustre une variante de réalisation de celle présentée sur la figure 10,
- La figure 13 illustre une simulation notamment de la chute de température obtenue par effet Ettingshausen grâce à l'usage d'au moins une gaine de bismuth, thermomagnétique.

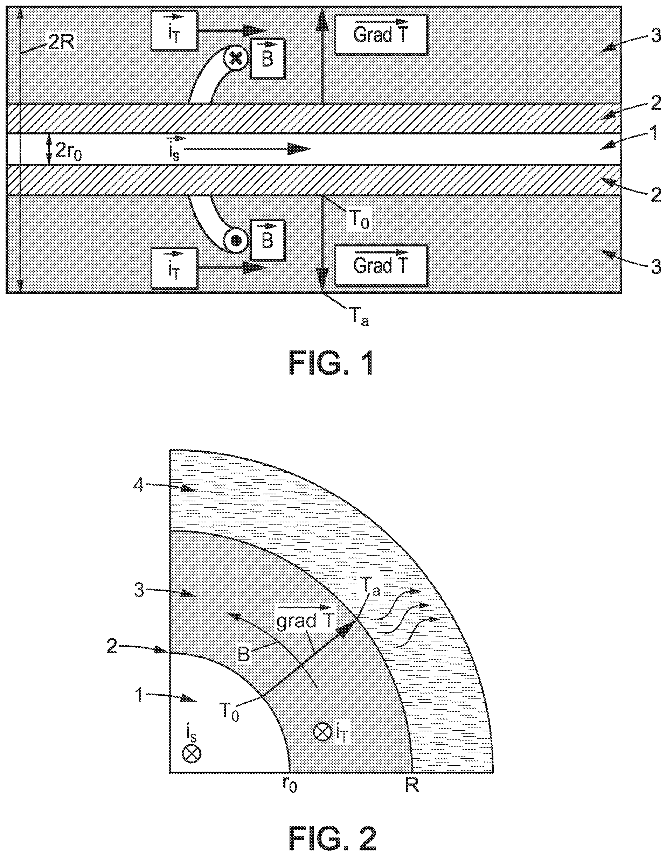

On se réfère tout d'abord à la figure 1, sur laquelle on a représenté une structure de câble au sens de l'invention, et comprenant :

- une âme 1, propre à véhiculer un courant principal $i_s$,
- entourée d'un isolant 2,
- entouré lui-même d'une gaine 3 réalisée dans un matériau thermomagnétique.

Le courant principal $i_s$ circulant dans l'âme 1 génère un champ magnétique B, notamment à l'extérieur de l'âme et en particulier dans la gaine 3 comportant le matériau thermomagnétique. Ce champ B est circulaire, autour de l'âme 1, comme représenté sur la figure 2.
Au sens de l'invention, on fait circuler en outre un courant auxiliaire $i_T$ dans la gaine 3, coopérant avec le champ magnétique B pour générer un gradient de température dans la gaine 3. Ce gradient de température est généré par l'effet Ettingshausen propre aux matériaux à propriétés thermomagnétiques : la coopération du courant $i_T$ avec le champ magnétique B « refroidit » ou « réchauffe » le matériau à proximité de l'âme du câble. Le gradient s'étend entre l'extérieur immédiat de l'âme 1 (à une température $T_0$) et l'extérieur immédiat de la gaine 3 (à une température $T_a$, correspondant sensiblement à la température ambiante générale à l'extérieur de la gaine 3). La température $T_0$ est inférieure ou supérieure à la température $T_a$ selon que le courant auxiliaire $i_T$ est par exemple dans le même sens ou respectivement en sens opposé du courant principal $i_s$.
L'effet Ettingshausen peut s'expliquer comme étant le phénomène inverse de l'effet Nernst : en soumettant un conducteur tel que le bismuth à un gradient de température et en lui appliquant un champ magnétique, Walther Nernst avait observé la circulation d'un courant (plus précisément une présence de voltage) transverse au gradient de température dû au gradient de température perpendiculaire au champ magnétique. Réciproquement, l'effet Ettingshausen consiste à appliquer un courant électrique et un champ magnétique, perpendiculaires, et il s'en suit un gradient de température transverse (vecteur gradT sur les figures 1 et 2).

Bien entendu, la valeur de la norme de ce gradient dépend des propriétés thermomagnétiques du matériau de la gaine. Par exemple, le bismuth, sur lequel avait été observé l'effet Nernst, possède des propriétés thermomagnétiques fortes permettant d'obtenir des différences de températures $|T_a-T_0|$ de l'ordre de dizaines de degrés (Celsius ou Kelvin, les températures étant comptées en Kelvins ci-après), comme détaillé plus loin en référence à la figure 4, issue des travaux présentés par :

Harman T.C. et al., dans Solid-State electronics, 7, 505 (1964)

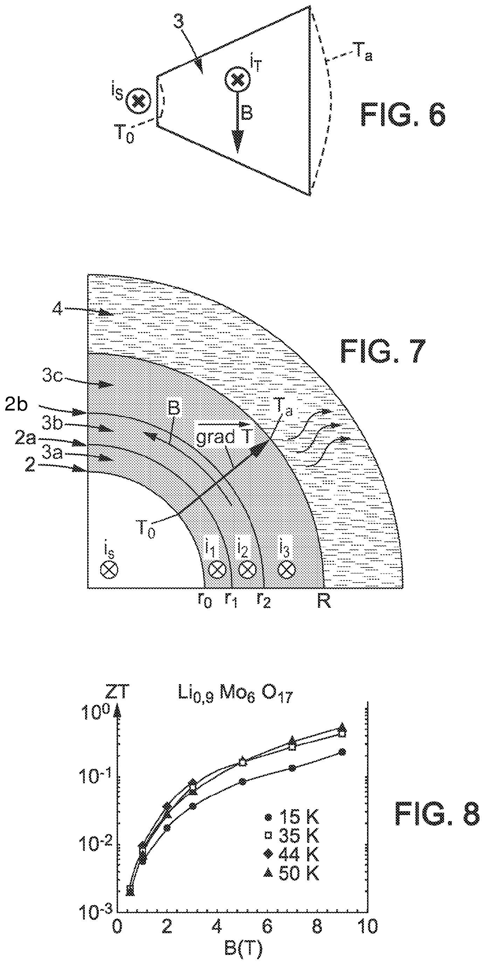

Néanmoins, d'autres matériaux alternatifs au bismuth, et reconnus pour leurs propriétés thermomagnétiques, peuvent constituer la gaine 3 du câble. On peut citer par exemple l'alliage $Li_{0,9}Mo_6O_{17}$, particulièrement performant à basse température comme détaillé plus loin en référence à la figure 8, issue des travaux présentés par :

Cohn J.L. et al., dans Physical Review Letters 108, 056604 (2012)

Un autre matériau tel qu'un alliage de fer et antimoine $FeSb_2$ présente aussi des propriétés thermomagnétiques, à plus faible niveau.

La propriété thermomagnétique d'un matériau se quantifie par ce qui est appelé la valeur de sa « figure de mérite ». L'expression de la figure de mérite est donnée en toute rigueur par : $Z=\alpha^2/\rho k$, où p est la résistivité, $\alpha$ est le pouvoir thermomagnétique ($\alpha$=NB, où N est le coefficient de Nernst et B le champ magnétique) et k la conductivité thermique du matériau. La résistivité p peut s'exprimer différemment selon les conditions « isotherme » ou « adiabatique » (absence de flux de chaleur ou absence de gradient de température transverse). Ainsi, l'expression de la figure de mérite Z peut alors être qualifiée elle-même de « isotherme » ou « adiabatique ».

On peut trouver des détails utiles dans le document :
Horst, J. Appl. Phys, 34, 3246 (1963).

Plus généralement, les paramètres qui interviennent dans l'expression de la figure de mérite sont propres à un matériau donné et dépendent tous de la température et du champ magnétique. Il est remarquable que dans le calcul notamment du gradient maximal de température $\Delta T$ qui peut être obtenu avec une géométrie donnée du matériau thermomagnétique, seule cette expression Z intervient.

Z, dans l'expression ci-avant, a les dimensions d'une température inverse. Souvent, on utilise pour plus de commodité la valeur dite « adimensionnelle » (isotherme ou adiabatique) de la figure de mérite, à savoir le produit de Z avec la température : ZT.

On décrit ci-après une expression de ce produit (ZT), en référence à la figure 3 qui présente la variation de la norme du gradient de température $\Delta T$ en fonction de l'intensité du courant $i_T$. Tout d'abord, afin d'expliquer la variation parabolique inversée de la différence $\Delta T$, il convient d'observer que l'effet Ettingshausen est en compétition avec l'effet Joule :

- en présence d'un champ magnétique constant B, plus le courant $i_T$ est élevé et plus l'effet Ettingshausen est marqué avec une différence $\Delta T$ élevée (début de la courbe parabolique),
- mais plus le courant $i_T$ augmente ensuite, et plus le matériau se réchauffe par effet Joule, ce qui estompe l'effet Ettingshausen en réduisant la différence de température $\Delta T$ (fin de la courbe parabolique).

On comprend ainsi qu'il existe, pour un champ magnétique donné B, une valeur optimale $i_{opt}$ du courant $i_T$.

A cette valeur optimale du courant $i_{opt}$, il correspond une différence de température maximale

$$\Delta T_{max} = \frac{1}{2}\, Z\, T_h^2 \, .$$

Cette expression peut se réécrire :

$$\Delta T_{max} = \frac{1}{2}\, (Z\, T_h)\, T_h \, ,$$

où :

- ($Z\ T_h$) est la valeur de la figure de mérite adimensionnelle du matériau (paramètre qui dépend du matériau considéré et notamment du champ magnétique B qui le traverse), et,
- $T_h$ est ici la valeur de la température ambiante (autour de la gaine, donc la référence $T_a$ des figures 1 et 2).

Dans ce qui suit, on appelle, par souci de simplification, simplement « figure de mérite » d'un matériau (par exemple supérieure à 0,01) cette grandeur adimensionnelle (ZT). Par ailleurs, la figure de mérite peut être « isotherme » ou « adiabatique » (comme le terme Z ci-avant). Sur la figure 4, par exemple, on a représenté la figure de mérite adimensionnelle (ZT), isotherme, du bismuth en fonction du champ magnétique B.

Ainsi, la figure 4 s'interprète comme suit :

- les triangles noirs à base vers le bas illustrent la variation de la valeur de la figure de mérite (ZT) du bismuth pur (Bi) en fonction de la valeur du champ magnétique B, à une température ambiante $T_a$ de 200°K : ainsi, pour un champ B de 5 Teslas, (ZT)=0,4

  pour $T_a = 200°K$ et $\Delta T_{max} = \frac{200}{2} . 0,4 = 40°K,$

- pour de plus faibles champs B, par exemple à 2 Teslas, il peut être avantageux d'utiliser plutôt un alliage de bismuth (Bi) avec 4% d'antimoine (Sb), comme matériau thermomagnétique, toujours dans la gamme de températures où $T_a$ est de 200°K (triangles blancs à base vers le bas).

Pour obtenir de telles valeurs de champ B (comprises entre 1 et 10 Teslas ou plus), le courant principal $i_s$ circulant dans l'âme du câble 1 peut avoir une densité de courant de l'ordre de 10000 A/cm$^2$ (10$^4$) ou plus. Ainsi, l'invention trouve une application avantageuse au transport électrique de haute puissance, avec une possibilité de refroidir l'âme du câble en prévoyant une circulation de courant auxiliaire $i_T$ dans une même direction que le courant principal $i_s$, comme représenté sur les figures 1 et 2 (avec dans ce cas $T_0<T_a$). Dans l'exemple de la figure 2, la gaine est dans un matériau thermomagnétique tel que, si la circulation du courant auxiliaire $i_T$ est dans le même sens que le courant principal $i_s$, alors la température est plus basse à cœur (avec $T_0<T_a$). Ainsi, dans cet exemple, l'inversion du sens du courant auxiliaire $i_T$ produit aussi une inversion du gradient de température avec alors $T_0>T_a$.

Avec de telles valeurs du champ B et du courant principal $i_s$, le courant auxiliaire $i_T$ peut avoir une valeur de densité de courant de l'ordre de 30 A/cm$^2$. Dans une forme de réalisation, la section de l'âme 1 (référencée 2r$_0$ sur la figure 1) est de l'ordre de 4cm, ce qui correspond à un courant principal de plus de 100kA, et la section de la gaine 3 (référencée 2R sur la figure 1) est de l'ordre de 8cm, ce qui correspond par exemple à un courant auxiliaire de l'ordre de 1000A.

Dès lors que les valeurs des courants principal $i_s$ et auxiliaire $i_T$ sont différentes, il convient de prévoir un isolant électrique 2 entre l'âme 1 et la gaine 3. Il peut s'agir par exemple d'un film 2 de téflon™ d'environ un millimètre d'épaisseur.

Comme indiqué précédemment, un abaissement de température $\Delta T_{max}$ de 40°K peut être escompté dans du bismuth pour un champ magnétique B de 5T, et une température $T_a$ de 200°K. Toutefois, il s'agit ici d'une considération du matériau thermomagnétique selon laquelle le matériau a une forme parallélépipédique comme illustré sur la figure 5. Il a été démontré que dans une forme sensiblement trapézoïdale (arrondie sur les côtés), il pouvait être obtenu un abaissement de température $\Delta T_{max}$ de plus de 100°K, selon les travaux présentés par :

Harman T.C. et al., dans Applied Physic Letters, 4, 77 (1964)

De telles valeurs d'abaissement de température dans ce type de forme peuvent s'expliquer par une meilleure répartition de la chaleur dans la forme évasée du trapèze.

Ainsi, dans une couronne de section de gaine 3 comme illustré sur la figure 6, des valeurs similaires d'abaissement de température justifient l'intérêt particulier de prévoir, au sens de l'invention, le matériau thermomagnétique agencé dans une gaine circulaire autour de l'âme (circulaire aussi) du câble. En outre, une structure de câble circulaire fermée (et non pas une nappe plate sur laquelle serait apposée un matériau thermomagnétique) permet d'isoler thermiquement l'âme du câble dans toutes les directions radiales, de façon efficace.

Eventuellement, il est possible de prévoir une feuille de bismuth d'environ 2 cm d'épaisseur, et d'y insérer en particulier des interstices isolants thermiques de section biconvexe pour reproduire parfaitement la forme du matériau thermomagnétique présentée dans le document Harman T.C. et al., dans Applied Physics Letters, 4, 77 (1964). On peut rouler ensuite cette feuille autour de l'âme et la solidariser ensuite à ses extrémités.

Un abaissement de température $\Delta T_{max}$ de l'ordre de 100°K peut ainsi être obtenu avec du bismuth dans la gaine 3 si la température ambiante est de l'ordre de 200°K. Une application avantageuse de l'invention consiste alors à prévoir un matériau supraconducteur dans l'âme 1 du câble. Par exemple, pour un matériau supraconducteur tel que l'YBaCuO à une température critique de 95°K, un abaissement de température de l'ordre de 100°K permet de prévoir une gaine de circulation de fluide de refroidissement à environ 195°K (plutôt 190°K pour assurer une marge de sécurité quant à la température critique). Dès lors, des alternatives possibles à l'azote liquide (dont la température de liquéfaction est de 77°K) s'offrent en tant que fluides de refroidissement d'un câble à supraconducteur (par exemple le dioxyde de carbone liquide sous pression, éventuellement mélangé à l'éther, dont la température de liquéfaction de 189°K est largement au-dessus de celle de l'azote liquide).

Pour initier la supraconductivité, on peut prévoir par exemple une âme à multibrins, avec des brins de câble en cuivre torsadés par exemple à des brins de câble supraconducteur, de sorte que la circulation du courant principal dans les brins de cuivre génère le champ magnétique B suffisant pour commencer à refroidir l'âme du câble et initier la supraconductivité grâce à la basse température obtenue par effet Ettingshausen. En variante ou en complément, on peut prévoir une température de liquide de refroidissement initialement plus basse que sa température de liquéfaction.

Par ailleurs, il est possible d'augmenter encore la différence de température (entre $T_a$ et $T_0$) en fractionnant la couronne thermomagnétique autour de l'âme, en plusieurs couronnes de dimensions et matériau optimisés. Par exemple, on peut tenir compte en particulier d'une décroissance radiale de l'amplitude du champ magnétique B. En effet, ce dernier est inversement proportionnel à la distance depuis l'âme 1, dans la gaine 3. Ainsi, pour reprendre l'exemple de la figure 4, il est possible de prévoir :

- une première gaine 3a (figure 7) autour de l'âme 1 comportant du bismuth pur pour une efficacité à 5 Teslas, puis
- une deuxième gaine 3b autour de la première gaine, comportant un alliage de bismuth et antimoine à 4% pour une efficacité à 2 Teslas.

Il est possible d'optimiser alors finement le courant $i_{opt}$ qui doit circuler dans les différentes gaines en fonction de leur rayon (ce courant $i_{opt}$ dépendant en outre du rayon).

Il est possible aussi d'augmenter encore la différence de température en tenant compte en particulier de paliers en température successivement atteints grâce à plusieurs gaines thermomagnétiques successives comportant des matériaux différents. Par exemple, en référence à la figure 7, on peut prévoir :

- une première gaine 3a autour de l'âme 1 comportant le matériau $Li_{0,9}Mo_6O_{17}$ lequel présente de bonnes performances thermomagnétiques à très basse température : autour de 50°K, comme le montre les valeurs de figures de mérite présentées en figure 8 (ici adiabatiques, et non isothermes comme sur la figure 4) avec un champ B supérieur ou de l'ordre de 10T,
- entourée d'une deuxième gaine 3b comportant du bismuth pur pour une efficacité à 5 Teslas,
- entourée d'une troisième gaine 3c comportant un alliage de bismuth et antimoine à 4% pour une efficacité à 2 Teslas.

Bien entendu, les différentes gaines sont séparées de films isolants électriques 2a, 2b.

Ainsi, il est possible de prévoir une pluralité de matériaux thermomagnétiques différents, choisis en fonction de leurs performances à des champs magnétiques B et à des températures $T_a$ bien déterminés. On entend d'ailleurs ici par « matériau thermomagnétique » un matériau capable d'avoir une valeur de figure de mérite supérieure à au moins $10^{-2}$ dans le contexte d'utilisation envisagé.

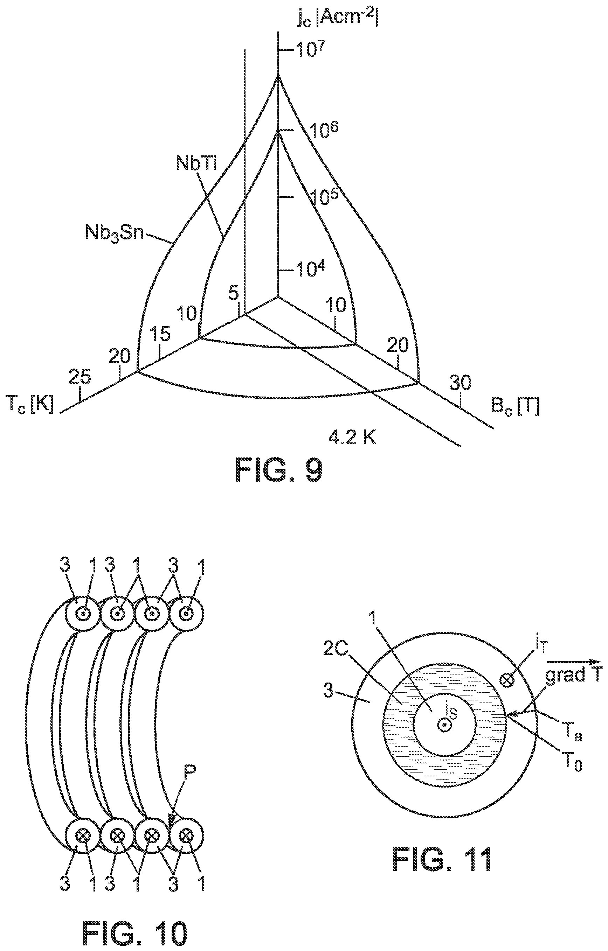

Par ailleurs, il est possible encore d'entourer l'âme et la gaine par une gaine de circulation de fluide de refroidissement 4, comme illustré sur la figure 7. Dans l'exemple de la figure 7, il est possible de prévoir une circulation d'azote liquide dans la gaine 4 (à 77°K), rendant possible l'utilisation de matériaux supraconducteurs tels que les pnictures à base de fer-arsenic ayant des températures critiques supérieures à 50°K, voire des matériaux à plus basses températures critiques tels que ceux à base de niobium tels que $Nb_3Sn$ et NbTi comme illustré sur la figure 9, issue des travaux présentés par : Chaddah P., dans "Critical current densities in superconducting materials", Sadhana vol. 28, p. 273 (2003)

Il apparait d'ailleurs sur cette figure 9 des valeurs de champ magnétique critique B (plus de 10T dans l'âme) et de densité de courant principal critique $i_s$ (plus de $10^4$ A/cm$^2$) qui sont en tous points compatibles avec l'usage d'une gaine à propriétés thermomagnétiques efficaces, au sens de l'invention.

De même, le composé $MgB_2$ présente une température critique de 39 K compatible avec une application de l'invention.

Néanmoins, d'autres applications que l'usage de supraconducteurs dans l'âme du câble peuvent être envisagées. Par exemple, l'invention peut s'appliquer dans des bobines de câble à fort courant principal et valeur élevée de champ magnétique extérieur B. De telles bobines, du type illustré sur la figure 10, sont utilisées notamment dans des scanners IRM, dans lesquels une détérioration classique est due à la chaleur accumulée notamment à la jointure P entre deux spires, fragilisant la tenue mécanique de la bobine. Au sens de l'invention, il peut être avantageux de prévoir un moyen de refroidissement de câble par l'adjonction d'une gaine 3 à propriétés thermomagnétiques et entourant l'âme 1 du câble en spirale, venant globalement apporter une température plus basse au câble.

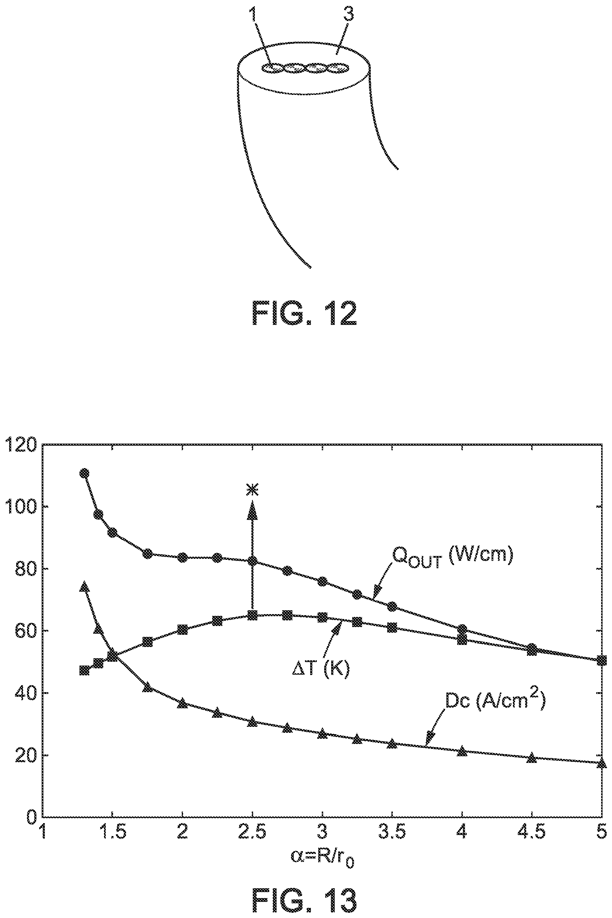

Dans la variante illustrée sur la figure 12, à la place d'embobiner l'âme du câble avec la gaine tout autour (comme illustré sur la figure 10), la gaine 3 peut englober entièrement la bobine de câble 1. En effet, sur la figure 10, la bobine perd en champ magnétique à cause de l'espace entre les spires, et la gaine, dans cet espace, a relativement moins d'effet que sur la figure 12 car le champ magnétique est nul à mi-chemin entre deux fils de bobine. Ainsi, la réalisation de la figure 12 peut être préférée dans certains contextes d'utilisation.

Comme indiqué précédemment, l'inversion du sens du courant auxiliaire $i_T$ par rapport au courant principal $i_s$ génère un gradient en sens opposé avec une température $T_0$ interne à la gaine thermomagnétique supérieure à la température ambiante $T_a$. Ainsi, une autre application de l'invention consiste à équiper les câbles à bain d'huile de haute puissance, d'une gaine thermomagnétique extérieure 3, comme illustré sur la figure 11, venant autour d'une gaine de circulation d'huile 2c, laquelle est agencée autour de l'âme 1 du câble électrique. Le sens du courant auxiliaire $i_T$ est inverse par rapport à celui qui était présenté dans l'exemple de la figure 1 (inverse par rapport au courant principal $i_s$ dans l'exemple de la figure 11) de sorte que la température $T_0$ de la gaine d'huile est supérieure à la température ambiante $T_a$. En principe, le fait que le courant auxiliaire soit dans le même sens que le courant principal ou en sens inverse pour générer un gradient dans un sens donné est lié à la nature du matériau utilisé pour la gaine. Dans l'exemple de la figure 11, la température $T_0$ de la gaine d'huile est alors supérieure à la température ambiante $T_a$ et cette réalisation est avantageuse pour éviter que l'huile ne se fige notamment en conditions de froid extrême.

On comprendra ainsi que l'invention ne se limite pas à une application de supraconductivité, ni à un refroidissement de câble, mais elle concerne plus généralement un traitement thermique de câble grâce à l'emploi d'au moins une gaine comportant un matériau thermomagnétique.

On a représenté sur la figure 13 les performances attendues d'un système de câble au sens de la présente invention. Il s'agit de simulations numériques pour atteindre un refroidissement maximum (avec

$$E_z = E_z^{max}(\alpha)$$

) à l'aide d'un refroidisseur circulaire à effet Ettingshausen. En particulier, cette simulation utilise des propriétés de matériaux réalistes tel que du bismuth monocristal, le long des axes du cristal pour une performance thermomagnétique maximale et un champ magnétique égal à $B_0$=12,6 T (plus généralement entre 10 et 15 T) à l'interface entre l'âme du câble et la gaine thermomagnétique. Ce champ est typiquement généré par une densité de courant de l'ordre de $10^5$ A/cm$^2$ (plus généralement entre $10^4$ et $10^6$ A/cm$^2$) dans une âme de câble de rayon $r_0$=2 cm (plus généralement quelques centimètres : entre 1 et 5 cm par exemple). La figure 13 illustre la chute de température correspondante $\Delta T$, ainsi que la chaleur dégagée par unité de longueur de câble $Q_{out}$, et la densité de courant moyenne De circulant dans la gaine thermomagnétique, en fonction de l'épaisseur de la gaine thermomagnétique $a = R/r_0$.

On donne en outre les performances attendues pour une réalisation à deux gaines thermomagnétiques (avec $R_1/r_0$ = 2,5 et $R_2/R_1$=0,02) et qui atteignent une différence de température de $\Delta T$=105,5 K (flèche de la figure 13). Cette différence de température de $\Delta T$=105,5 K est atteinte à partir d'une température extérieure de 300K, pour deux gaines de bismuth, mais avec des densités de courants différentes, adaptées respectivement pour atteindre une différence de température maximale (avec

$$E_z = E_z^{max}(\alpha)$$

).

**Revendications**

1. Câble électrique, comportant une âme (1) destinée à faire circuler un courant électrique principal ($i_s$) générant un champ magnétique circulaire (B) au moins à l'extérieur de l'âme (1), **caractérisé en ce qu'il** comporte au moins une gaine (3) entourant l'âme (1) et comportant un matériau thermomagnétique, la gaine (3) étant conductrice pour faire circuler un courant électrique auxiliaire ($i_T$) coopérant avec le champ magnétique circulaire (B) pour générer, par effet Ettingshausen, un gradient de température entre l'âme (1) du câble et l'extérieur de la gaine (3).

2. Câble selon la revendication 1, **caractérisé en ce que** le matériau thermomagnétique de la gaine (3) comporte du bismuth.

3. Câble selon l'une des revendications 1 et 2, **caractérisé en ce que** le matériau thermomagnétique de la gaine (3) comporte un alliage de bismuth et d'antimoine.

4. Câble selon la revendication 3, **caractérisé en ce que** la proportion d'antimoine dans l'alliage est de moins de 10%.

5. Câble selon la revendication 1, **caractérisé en ce que** le matériau thermomagnétique de la gaine (3) comporte un oxyde de molybdène et lithium.

6. Câble selon la revendication 5, **caractérisé en ce que** le matériau thermomagnétique de la gaine (3) comporte du $Li_{0,9}Mo_6O_{17}$.

7. Câble selon l'une des revendications précédentes, **caractérisé en ce que** le matériau thermomagnétique de la gaine (3) présente une valeur de figure de mérite supérieure à $10^{-2}$.

8. Câble selon l'une des revendications précédentes, **caractérisé en ce qu'il** comporte :

   - une première gaine (3a) comportant un premier matériau thermomagnétique, conducteur pour faire circuler un premier courant auxiliaire et, de là, refroidir l'âme du câble, et
   - au moins une seconde gaine (3b) entourant la première gaine (3a) et comportant un deuxième matériau thermomagnétique, conducteur pour faire circuler un deuxième courant auxiliaire et, de là, refroidir la première gaine (3a), les premier et deuxième matériaux thermomagnétiques étant différents et/ou les premier et deuxième courants auxiliaires étant différents.

9. Câble selon l'une des revendications précédentes, **caractérisé en ce que** l'âme (1) comporte un matériau supraconducteur.

10. Câble selon l'une des revendications précédentes, **caractérisé en ce que** la gaine (3) comportant le matériau thermomagnétique est entourée d'une gaine de circulation d'un fluide de refroidissement.

11. Câble selon l'une des revendications précédentes, **caractérisé en ce qu'il** comporte au moins un film isolant électrique (2, 2a, 2b) entre l'âme (1) et la gaine (3, 3a, 3b, 3c).

12. Procédé de traitement en température de l'âme d'un câble électrique, **caractérisé en ce qu'il** comporte les étapes :

- prévoir au moins une gaine (3) entourant l'âme (1) du câble, et comportant un matériau thermomagnétique, et

- concomitamment à une circulation de courant électrique principal ($i_S$) dans l'âme (1), générant un champ magnétique circulaire (B) au moins à l'extérieur de l'âme (1), faire circuler un courant électrique auxiliaire ($i_T$) coopérant avec le champ magnétique circulaire (B) pour générer, par effet Ettingshausen, un gradient de température entre l'âme (1) du câble et l'extérieur de la gaine (3).

**13.** Procédé selon la revendication 12, dans lequel :

- le courant principal ($i_S$) générant le champ magnétique (B) circule le long de l'âme (1) du câble, et

- le champ magnétique (B) généré est perpendiculaire à l'âme (1), **caractérisé en ce que** l'on fait circuler le courant auxiliaire ($i_T$) dans une direction parallèle à l'âme (1) du câble pour générer un gradient de température dans une direction perpendiculaire à l'âme (1).

**14.** Procédé selon la revendication 13, **caractérisé en ce que** l'on fait circuler le courant auxiliaire ($i_T$) dans un sens choisi par rapport au courant principal ($i_S$) circulant dans l'âme (1), pour générer un gradient de température refroidissant l'âme (1) du câble.

**15.** Procédé selon la revendication 14, dans lequel on prévoit un matériau supraconducteur dans l'âme (1) du câble, **caractérisé en ce que** :

- on prévoit en outre une gaine de circulation d'un fluide de refroidissement entourant la gaine (3) comportant le matériau thermomagnétique, et

- on injecte dans la gaine de circulation un fluide à une température plus basse qu'une température critique du matériau supraconducteur au moins pour amorcer un effet supraconducteur dans l'âme (1) du câble.


**Patentansprüche**

**1.** Elektrisches Kabel, welches einen Kern (1) umfasst, der dazu bestimmt ist, einen elektrischen Hauptstrom (is) fließen zu lassen, der ein kreisförmiges Magnetfeld (B) wenigstens außerhalb des Kerns (1) erzeugt, **dadurch gekennzeichnet, dass** es wenigstens eine Hülle (3) aufweist, die den Kern (1) umgibt und ein thermomagnetisches Material umfasst, wobei die Hülle (3) leitfähig ist, um einen elektrischen Hilfsstrom ($i_T$) fließen zu lassen, der mit dem kreisförmigen Magnetfeld (B) zusammenwirkt, um durch den Ettingshausen-Effekt einen Temperaturgradienten zwischen dem Kern (1) des Kabels und der Außenseite der Hülle (3) zu erzeugen.

**2.** Kabel nach Anspruch 1, **dadurch gekennzeichnet, dass** das thermomagnetische Material der Hülle (3) Wismut umfasst.

**3.** Kabel nach einem der Ansprüche 1 und 2, **dadurch gekennzeichnet, dass** das thermomagnetische Material der Hülle (3) eine Legierung aus Wismut und Antimon umfasst.

**4.** Kabel nach Anspruch 3, **dadurch gekennzeichnet, dass** der Antimon-Anteil in der Legierung weniger als 10 % beträgt.

**5.** Kabel nach Anspruch 1, **dadurch gekennzeichnet, dass** das thermomagnetische Material der Hülle (3) ein Molybdänoxid und Lithium umfasst.

**6.** Kabel nach Anspruch 5, **dadurch gekennzeichnet, dass** das thermomagnetische Material der Hülle (3) $Li_{0,9}Mo_6O_{17}$ umfasst.

**7.** Kabel nach einem der vorhergehenden Ansprüche, **dadurch gekennzeichnet, dass** das thermomagnetische Material der Hülle (3) einen Gütefaktor größer $10^{-2}$ aufweist.

**8.** Kabel nach einem der vorhergehenden Ansprüche, **dadurch gekennzeichnet, dass** es umfasst:

- eine erste Hülle (3a), die ein erstes thermomagnetisches, leitfähiges Material umfasst, um einen ersten Hilfsstrom fließen zu lassen und dadurch den Kern des Kabels zu kühlen, und
- wenigstens eine zweite Hülle (3b), die den ersten Mantel (3a) umgibt und ein zweites thermomagnetisches Material umfasst, das leitfähig ist, um einen zweiten Hilfsstrom fließen zu lassen und dadurch den ersten Mantel (3a) zu kühlen, wobei sich das erste und zweite thermomagnetische Material und/oder der erste und zweite Hilfsstrom unterscheiden.

**9.** Kabel nach einem der vorhergehenden Ansprüche, **dadurch gekennzeichnet, dass** der Kern (1) ein supraleitendes Material umfasst.

**10.** Kabel nach einem der vorhergehenden Ansprüche, **dadurch gekennzeichnet, dass** die Hülle (3), die das thermomagnetische Material umfasst, von einer Hülle für die Zirkulation einer Kühlflüssigkeit umgeben ist.

**11.** Kabel nach einem der vorhergehenden Ansprüche, **dadurch gekennzeichnet, dass** es wenigstens ei-

8

ne elektrisch isolierende Folie (2, 2a, 2b) zwischen dem Kern (1) und der Hülle (3, 3a, 3b, 3c) aufweist.

12. Verfahren zur Temperaturbehandlung des Kerns eines elektrischen Kabels, **dadurch gekennzeichnet, dass** es die folgenden Schritte umfasst:

- Vorsehen wenigstens einer Hülle (3), die den Kern (1) des Kabels umgibt und ein thermomagnetisches Material umfasst, und
- in Verbindung mit einem Fluss des elektrischen Hauptstroms (is) in dem Kern (1), der ein kreisförmiges Magnetfeld (B) wenigstens außerhalb des Kerns (1) erzeugt, Fluss eines elektrischen Hilfsstroms ($i_T$), der mit dem kreisförmigen Magnetfeld (B) zusammenwirkt, um durch den Ettingshausen-Effekt einen Temperaturgradienten zwischen dem Kern (1) des Kabels und der Außenseite der Hülle (3) zu erzeugen.

13. Verfahren nach Anspruch 12, wobei:

- der Hauptstrom (is), der das Magnetfeld (B) erzeugt, entlang des Kerns (1) des Kabels fließt, und
- das erzeugte Magnetfeld (B) senkrecht zum Kern (1) ist, **dadurch gekennzeichnet, dass** man den Hilfsstrom ($i_T$) in einer Richtung parallel zum Kern (1) des Kabels fließen lässt, um einen Temperaturgradienten in einer Richtung senkrecht zum Kern (1) zu erzeugen.

14. Verfahren nach Anspruch 13, **dadurch gekennzeichnet, dass** man den Hilfsstrom ($i_T$) in einer gewählten Richtung relativ zum Hauptstrom (is) fließen lässt, der durch den Kern (1) fließt, um einen Temperaturgradienten zu erzeugen, der den Kern (1) des Kabels kühlt.

15. Verfahren nach Anspruch 14, wobei ein supraleitendes Material in dem Kern (1) des Kabels vorgesehen wird, **dadurch gekennzeichnet, dass**:

- ferner eine Hülle für die Zirkulation eines Kühlfluids vorgesehen wird, welches die Hülle (3), die das thermomagnetische Material umfasst, umgibt, und
- ein Fluid mit einer Temperatur, die niedriger als eine kritische Temperatur des supraleitenden Materials ist, in die Zirkulationshülle injiziert wird, um wenigstens einen supraleitenden Effekt in dem Kern (1) des Kabels zu initiieren.

**Claims**

1. Electrical cable, comprising a core (1) intended to conduct a main electric current (is) generating a circular magnetic field (B) at least outside the core (1), **characterized in that** it comprises at least one cladding (3) surrounding the core (1) and comprising a thermomagnetic material, the cladding (3) being conductive in order to conduct an auxiliary electric current ($i_T$) that interacts with the circular magnetic field (B) in order to generate, via the Ettingshausen effect, a temperature gradient between the core (1) of the cable and the exterior of the cladding (3).

2. Cable according to claim 1, wherein the thermomagnetic material of the cladding (3) comprises bismuth.

3. Cable according to one of claims 1 and 2, wherein the thermomagnetic material of the cladding (3) comprises an alloy of bismuth and antimony.

4. Cable according to claim 3, wherein the proportion of antimony in the alloy is less than 10%.

5. Cable according to claim 1, wherein the thermomagnetic material of the cladding (3) comprises a molybdenum oxide and lithium.

6. Cable according to claim 5, wherein the thermomagnetic material of the cladding (3) comprises $Li_{0.9}Mo_6O_{17}$.

7. Cable according to one of the preceding claims, wherein the thermomagnetic material of the cladding (3) has a figure of merit value greater than $10^{-2}$.

8. Cable according to one of the preceding claims, wherein it comprises:

- a first cladding (3a) comprising a first thermomagnetic material that is conductive in order to conduct a first auxiliary current, and hence to cool the core of the cable, and
- at least a second cladding (3b) surrounding the first cladding (3a) and comprising a second thermomagnetic material that is conductive in order to conduct a second auxiliary current, and hence to cool the first cladding (3a),

the first and second thermomagnetic materials being different and/or the first and second auxiliary currents being different.

9. Cable according to one of the preceding claims, wherein the core (1) comprises a supraconductor.

10. Cable according to one of the preceding claims, wherein the cladding (3) comprising the thermomagnetic material is surrounded by a cladding for the circulation of a cooling fluid.

11. Cable according to one of the preceding claims, wherein it comprises at least one electrically insulating film (2, 2a, 2b) between the core (1) and the cladding (3, 3a, 3b, 3c).

12. Method for temperature treatment of the core of an electrical cable, comprising the following steps:

- providing at least one cladding (3) surrounding the core (1) of the cable, and comprising a thermomagnetic material, and
- concomitantly with a conduction of main electric current (is) in the core (1) which generates a circular magnetic field (B) at least outside the core (1), conducting an auxiliary electric current ($i_T$) interacting with the circular magnetic field (B) in order to generate, via the Ettingshausen effect, a temperature gradient between the core (1) of the cable and the exterior of the cladding (3).

13. Method according to claim 12, wherein:

- the main current (is) generating the magnetic field (B) is conducted along the core (1) of the cable, and
- the magnetic field (B) generated is perpendicular to the core (1),

characterized in that the auxiliary current ($i_T$) is conducted in a direction parallel to the core (1) of the cable in order to generate a temperature gradient in a direction perpendicular to the core (1).

14. Method according to claim 13, wherein the auxiliary current ($i_T$) is conducted in a chosen direction relative to the main current (is) conducted in the core (1), in order to generate a temperature gradient cooling the core (1) of the cable.

15. Method according to claim 14, wherein a supraconductor is provided in the core (1) of the cable, characterized in that:

- a cladding for the flow of a cooling fluid is provided, surrounding the cladding (3) comprising the thermomagnetic material, and
- injected into the flow cladding is a fluid at a temperature lower than a critical temperature of the supraconductor at least in order to initiate a supraconductive effect in the core (1) of the cable.

**FIG. 1**

**FIG. 2**

FIG. 3

FIG. 4

FIG. 5

FIG. 6

FIG. 7

FIG. 8

FIG. 9

FIG. 10

FIG. 11

FIG. 12

FIG. 13

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 1244209 B

**Littérature non-brevet citée dans la description**

- **HARMAN T.C. et al.** *Solid-State electronics,* 1964, vol. 7, 505
- **COHN J.L. et al.** *Physical Review Letters,* 2012, vol. 108, 056604
- **HORST.** *J. Appl. Phys,* 1963, vol. 34, 3246
- **HARMAN T.C. et al.** *Applied Physic Letters,* 1964, vol. 4, 77
- **HARMAN T.C. et al.** *Applied Physics Letters,* 1964, vol. 4, 77
- **CHADDAH P.** Critical current densities in superconducting materials. *Sadhana,* 2003, vol. 28, 273